(19) Europäisches Patentamt
European Patent Office
Office européen des brevets

(11) **EP 4 685 846 A1**

(12) **EUROPEAN PATENT APPLICATION**
published in accordance with Art. 153(4) EPC

(43) Date of publication:
**28.01.2026 Bulletin 2026/05**

(21) Application number: **24779879.6**

(22) Date of filing: **21.03.2024**

(51) International Patent Classification (IPC):
*H01L 23/12* (2006.01)   *G09F 9/00* (2006.01)
*H01L 23/14* (2006.01)   *H05K 1/02* (2006.01)

(52) Cooperative Patent Classification (CPC):
**G09F 9/00; H01L 23/12; H01L 23/14; H05K 1/02**

(86) International application number:
**PCT/JP2024/011127**

(87) International publication number:
**WO 2024/203760 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.03.2023 JP 2023051523**

(71) Applicant: **TDK Corporation**
**Tokyo 103-6128 (JP)**

(72) Inventors:
• **NISHIOKA Keisuke**
**Tokyo 103-6128 (JP)**
• **SHINGAI Hiroshi**
**Tokyo 103-6128 (JP)**
• **YONEDA Mayumi**
**Tokyo 103-6128 (JP)**
• **NISHIZAWA Akinori**
**Tokyo 103-6128 (JP)**

(74) Representative: **Epping - Hermann - Fischer Patentanwaltsgesellschaft mbH**
**Schloßschmidstraße 5**
**80639 München (DE)**

(54) **CONDUCTIVE FILM AND DISPLAY DEVICE**

(57)   A conductive film includes a substrate, a resin layer provided on a main surface of the substrate, and a conductive part with which a groove pattern formed in at least the resin layer is filled. The resin layer is obtained using a resin composition containing a release agent containing silicon, and a resin, the resin layer includes a surface-segregated release agent layer and a main body portion provided on the substrate side of the surface-segregated release agent layer, the surface-segregated release agent layer has a first surface opposite to the main body portion, and the main body portion has a second surface on the substrate side. The thickness of the resin layer is 5100 nm or less, and in a case where the resin layer is subjected to time-of-flight secondary ion mass spectrometry in the thickness direction of the resin layer, a ratio R defined by the following Formula (1) using an intensity A1 of silicon-containing secondary ions derived from the release agent in the first surface of the main body portion and an intensity A2 of silicon-containing secondary ions derived from the release agent in the second surface of the surface-segregated release agent layer is 25% or less.

$$\text{Ratio R} = 100 \times A2/A1 \cdots (1)$$

**Fig.4**

## Description

### Technical Field

The present disclosure relates to a conductive film and a display device.

### Background Art

A conductive film including a transparent antenna having transparency and conductivity may be mounted on a surface of a touch panel or a display.

As such a conductive film, for example, Patent Literature 1 described below discloses a conductive film formed by forming a trench-forming layer on a laminate composed of a base material and a base layer, pressing a mold having protrusions onto a resin composition for forming the trench-forming layer until the protrusions are brought into contact with the base layer by an imprinting method to form a mesh-like trench pattern having linear trenches, and filling the trench pattern with conductive parts to form a mesh-like conductive pattern.

### Citation List

### Patent Literature

Patent Literature 1: Japanese Unexamined Patent Publication No. 2019-029658

### Summary of Invention

### Technical Problem

In a case where a trench pattern is formed in a trench-forming layer by an imprinting method as in the conductive film of Patent Literature 1, a release agent may be added to a resin composition for forming the trench-forming layer for the purpose of improving releasability of a mold from a resin layer after the trench-forming layer is cured to form the resin layer.

However, in a case where the release agent is added in the resin composition, the conductive film described in Patent Literature 1 encounters the following issues.

That is, the conductive film described in Patent Literature 1 described above has room for improvement in terms of adhesion of the resin layer to a substrate.

However, the conductive film described in Patent Literature 1 described above has room for improvement in terms of chemical resistance.

An object of the present disclosure is to provide a conductive film including a resin layer excellent in adhesivess and chemical resistance and a display device.

### Solution to Problem

One aspect of the present disclosure provides a conductive film including: a substrate; a resin layer provided on one or each of two main surfaces of the substrate; a groove pattern formed in at least the resin layer; and a conductive part with which the groove pattern is filled, in which the resin layer is obtained using a resin composition containing a release agent containing silicon and a resin, the resin layer includes a surface-segregated release agent layer in which the release agent segregates, and a main body portion provided on a substrate side of the surface-segregated release agent layer, the surface-segregated release agent layer has a first surface opposite to the main body portion, the main body portion has a second surface on the substrate side, a thickness of the resin layer is 5100 nm or less, and in a case where the resin layer is subjected to time-of-flight secondary ion mass spectrometry in a thickness direction of the resin layer, a ratio R defined by Formula (1) using an intensity $A1$ of silicon-containing secondary ions derived from the release agent in the first surface of the main body portion and an intensity $A2$ of silicon-containing secondary ions derived from the release agent in the second surface of the main body portion is 25% or less.

$$\text{Ratio } R = 100 \times A2/A1 \cdots (1)$$

According to this conductive film, in a case where a part of the resin layer provided on the one or each of the two main surfaces of the substrate is defined as the surface-segregated release agent layer in which the release agent segregates, the remainder is defined as the main body portion, and the ratio R represented by the above-described Formula (1) using the intensity of the silicon-containing secondary ions derived from the release agent is set to 25% or less, on the second surface of the main body portion with respect to the first surface of the surface-segregated release agent layer, the amount of the release agent on the second surface in the main body portion can be reduced as compared to a case where the ratio R is made larger than 25%. In addition, by setting the thickness of the resin layer to 5100 nm or less, the adhesion area between the resin layer and the substrate per unit thickness can be increased. Therefore, the conductive film of the present disclosure exhibits excellent adhesion of the resin layer to the substrate. On the other hand, by setting the ratio R to 25% or less, the resin is protected from chemicals in the resin layer even though the resin layer is brought into contact with chemicals. Therefore, the conductive film of the present disclosure also exhibits excellent chemical resistance.

Another aspect of the present disclosure provides a display device including: an image display unit; and a conductive film provided over the image display unit, in which the conductive film is the above-described conductive film.

Since the conductive film exhibits excellent adhesion of the resin layer, formation of voids that cause light scattering between the substrate and the resin layer is minimized over a long period of time, and a decrease in transmittance due to the voids is minimized. In addition, since the above-described conductive film also exhibits excellent chemical resistance, deterioration of the resin due to chemicals is minimized even though the conductive film is brought into contact with the chemicals, and deterioration of transparency of the conductive film due to deterioration of the resin is minimized over a long period of time. Therefore, in the display device of the present disclosure, a decrease in visibility of the image display unit through the conductive film can be minimized over a long period of time.

In the above-described conductive film, the thickness of the surface-segregated release agent layer is preferably 30% or less of the thickness of the resin layer.

In this case, the conductive film exhibits more excellent adhesion and chemical resistance of the resin layer as compared to a case where the thickness of the surface-segregated release agent layer is more than 30% of the thickness of the resin layer.

In the above-described conductive film, the above-described ratio R is preferably 20% or less.

In this case, the conductive film exhibits more excellent adhesion and chemical resistance of the resin layer as compared to a case where the ratio R is more than 20%.

In the above-described conductive film, the substrate may include a base layer in contact with the resin layer, and the base layer may contain at least one metal selected from the group consisting of palladium, copper, nickel, and aluminum.

In the above-described conductive film, the groove pattern may include a plurality of linear trenches intersecting each other.

In the above-described conductive film, the groove pattern may be a mesh-like pattern.

Since the conductive film exhibits excellent adhesion of the resin layer, formation of voids that cause light scattering between the substrate and the resin layer is minimized over a long period of time, and a decrease in transmittance due to the voids is minimized. In addition, since the above-described conductive film also exhibits excellent chemical resistance, deterioration of the resin due to chemicals is minimized even though the conductive film is brought into contact with the chemicals, and deterioration of transparency of the conductive film due to deterioration of the resin is minimized over a long period of time. Therefore, the above-described conductive film is useful when used for a transparent antenna.

In the present disclosure, the "surface-segregated release agent layer" refers to a region in which the intensity of the silicon-containing secondary ions derived from the release agent is maintained in a range of -75% to +75% based on the intensity of the silicon-containing secondary ions in the first surface in a case where the time-of-flight secondary ion mass spectrometry is performed on the resin layer in the thickness direction thereof.

**Advantageous Effects of Invention**

According to the present disclosure, the conductive film and the display device, which exhibit excellent adhesion and chemical resistance of the resin layer, are provided.

**Brief Description of Drawings**

FIG. 1 is a plan view illustrating a conductive film according to an embodiment of the present disclosure.
FIG. 2 is a cross-sectional view taken along line II-II in FIG. 1.
FIG. 3 is an enlarged plan view of the vicinity of an intersecting portion where two linear trenches and two linear portions of conductive parts intersect each other.
FIG. 4 is a partially enlarged view of FIG. 2.

FIG. 5 is a cross-sectional view illustrating an embodiment of a display device of the present disclosure.

FIG. 6 is a graph illustrating the relationship between the depth from a first surface and the intensity of silicon-containing secondary ions derived from a release agent according to Example 1.

## Description of Embodiments

Embodiments of the present disclosure will be described in detail below.

<Conductive Film>

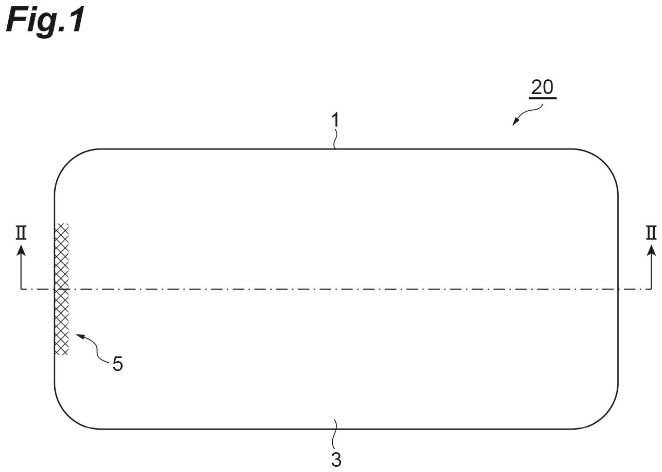

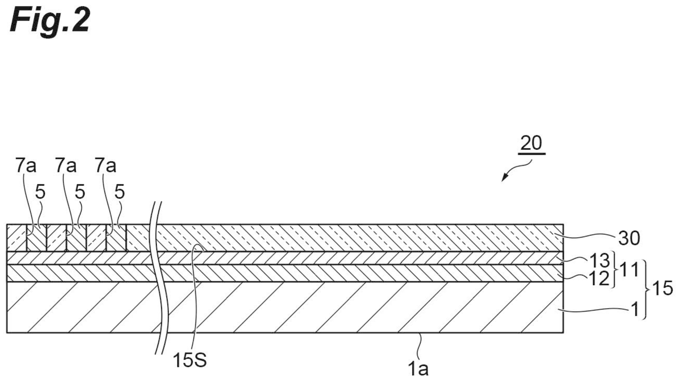

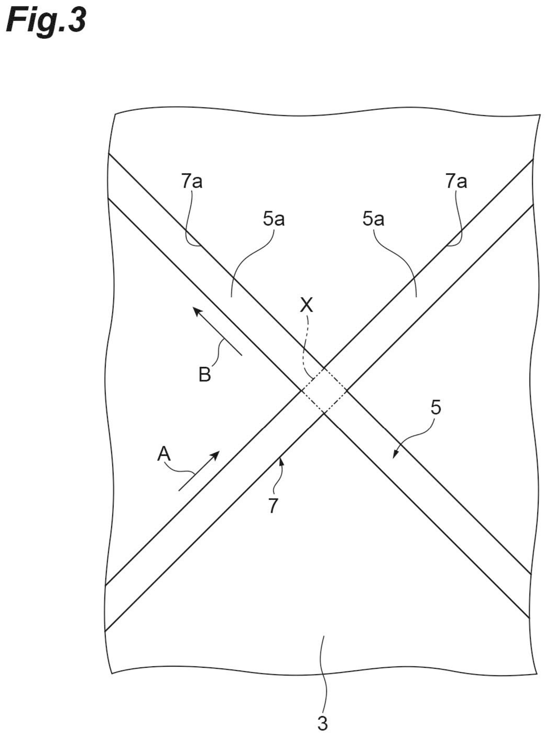

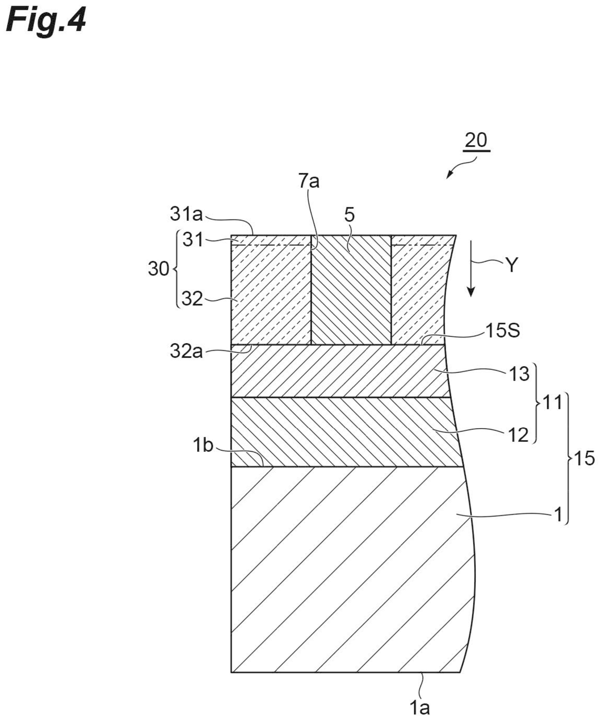

First, an embodiment of a conductive film of the present disclosure will be described with reference to the drawings. FIG. 1 is a plan view illustrating a conductive film according to an embodiment of the present disclosure. FIG. 2 is a cross-sectional view taken along line II-II in FIG. 1. FIG. 3 is an enlarged plan view of the vicinity of an intersecting portion where two linear trenches and two linear portions of conductive parts intersect each other. FIG. 4 is a partially enlarged view of FIG. 2.

As illustrated in FIGS. 1 to 4, a conductive film 20 mainly includes a substrate 15, a first resin layer 30 provided on one main surface 15S of the substrate 15, a groove pattern 7 formed in the first resin layer 30, and a conductive part 5 with which the groove pattern 7 is filled. The first resin layer 30 is obtained using a resin composition, and the resin composition contains a release agent containing silicon and a resin. The first resin layer 30 includes a surface-segregated release agent layer 31 in which a release agent segregates, and a main body portion 32 provided on the substrate 15 of the surface-segregated release agent layer 31. The surface-segregated release agent layer 31 has a first surface 31a on the side opposite to the main body portion 32, and the main body portion 32 has a second surface 32a on the side facing the substrate 15. Furthermore, the thickness of the first resin layer 30 is 5100 nm or less. In the conductive film 20, in a case where time-of-flight secondary ion mass spectrometry (TOF-SIMS) is performed on the first resin layer 30 in a thickness direction Y thereof, a ratio R defined by the following Formula (1) using an intensity A1 of silicon-containing secondary ions derived from the release agent in the first surface 31a of the surface-segregated release agent layer 31 and an intensity A2 of silicon-containing secondary ions derived from the release agent in the second surface 32a of the main body portion 32 is 25% or less.

$$\text{Ratio } R = 100 \times A2/A1 \cdots (1)$$

The substrate 15 includes a film-like base material 1 and an intermediate layer 11 provided between the base material 1 and the first resin layer 30. The intermediate layer 11 includes a second resin layer 12 and a base layer 13 in this order from the base material 1 side. The conductive film 20 may further include a protective layer (not illustrated) on the main surface 1a of the base material 1 opposite to the first resin layer 30 and the intermediate layer 11.

In the conductive film 20, as illustrated in FIG. 3, a plurality of linear trenches 7a extending along each of two directions A and B and intersecting each other at an intersecting portion X to form a mesh-like groove pattern 7.

The conductive part 5 has a portion (linear portion) 5a provided in a linear trench 7a. The conductive part 5 in the groove pattern 7 having the trenches 7a also forms a mesh-like pattern.

According to the conductive film 20, in a case where a part of the first resin layer 30 provided on the one main surface 15S of the substrate 15 is defined as the surface-segregated release agent layer 31 in which the release agent segregates, the remainder is defined as the main body portion 32, and the ratio R represented by the above-described Formula (1) using the intensity of the silicon-containing secondary ions derived from the release agent is set to 25% or less, on the second surface 32a of the main body portion 32 with respect to the first surface 31a of the surface-segregated release agent layer 31, the amount of the release agent on the second surface 32a of the main body portion 32 can be reduced as compared to a case where the ratio R is made larger than 25%. In addition, by setting the thickness of the first resin layer 30 to 5100 nm or less, the adhesion area between the first resin layer 30 and the substrate 15 per unit thickness can be increased. Therefore, the conductive film 20 is excellent in adhesion of the first resin layer 30 to the substrate 15. On the other hand, by setting the ratio R to 25% or less, the resin is protected from chemicals in the first resin layer 30 even though the resin in the first resin layer 30 is brought into contact with chemicals. Therefore, the conductive film 20 also exhibits excellent chemical resistance.

Since the conductive film 20 is excellent in adhesion of the first resin layer 30, formation of voids that cause light scattering between the substrate 15 and the first resin layer 30 is minimized over a long period of time, and a decrease in transmittance due to the voids is minimized. In addition, since the conductive film 20 also exhibits excellent chemical resistance, deterioration of the resin due to chemicals is minimized even though the conductive film 20 is brought into contact with the chemicals, and deterioration of transparency of the conductive film 20 due to deterioration of the resin is minimized over a long period of time. Therefore, the conductive film 20 is useful when used for a transparent antenna. In particular, the conductive part 5 having the mesh-like pattern can function well as, for example, a radiating element of an antenna.

Hereinafter, the base material 1, the first resin layer 30, the second resin layer 12, the base layer 13, the groove pattern 7, the conductive part 5, and the protective layer will be described in detail.

(Base Material)

The base material 1 may be a light transmissive base material. The light transmissive base material has, for example, light transmissivity to an extent required when the conductive film 20 is incorporated in a display device. Specifically, the total light transmittance of the light-transmissing base material may be 90% to 100%. The light transmissive base material may have a haze of 0% to 5%.

The light transmissive base material used as the base material 1 may be, for example, a transparent resin film, and examples thereof include a film of polyethylene terephthalate (PET), polycarbonate (PC), polyethylene naphthalate (PEN), cycloolefin polymer (COP), or polyimide (PI). Alternatively, the light transmissive base material may be a glass substrate.

The thickness of the base material 1 may be 1 $\mu$m or more, 10 $\mu$m or more, or 20 $\mu$m or more, and may be 500 $\mu$m or less, 200 $\mu$m or less, or 100 $\mu$m or less.

(First Resin Layer)

The first resin layer 30 is formed using a resin composition containing a resin and a release agent that contains silicon. The first resin layer 30 may be composed of the resin composition or may contain a cured product of the resin composition. The total light transmittance of the first resin layer 30 may be 90% to 100%. The first resin layer 30 may have a haze of 0% to 5%.

The resin of the resin composition may be a curable resin composition or a cured product thereof. Examples of the above-described curable resin include an acrylic resin, an amino resin, a cyanate resin, an isocyanate resin, a polyimide resin, an epoxy resin, an oxetane resin, a polyester resin, an allyl resin, a phenolic resin, a benzoxazine resin, a xylene resin, a ketone resin, a furan resin, a COPNA resin, a silicon resin, a dicyclopentadiene resin, a benzocyclobutene resin, an episulfide resin, an ene-thiol resin, a polyazomethine resin, a polyvinyl benzyl ether compound, acenaphthylene, and an ultraviolet curable resin containing a functional group that causes a polymerization reaction with ultraviolet rays such as an unsaturated double bond, a cyclic ether, and a vinyl ether.

Examples of the release agent containing silicon include a release agent having an ultraviolet-curable functional group or heat-curable functional group such as acrylic-modified reactive silicone oil or epoxy-modified reactive silicone oil, and a release agent having a functional group capable of crosslinking reaction with a curable resin. Among them, the release agent having a functional group capable of crosslinking reaction with a curable resin is preferable. In this case, the strength and chemical resistance of the first resin layer 30, obtained by crosslinking with a curable resin, are further improved. The release agent may be used singly or in combination of two or more kinds thereof.

The content of the release agent in the resin composition is not particularly limited, and is preferably 30 mass% or less, more preferably 20 mass% or less, and particularly preferably 15 mass% or less. In a case where the content of the release agent in the resin composition is 30 mass% or less, the adhesion of the first resin layer 30 to the substrate 15 can be further improved as compared to a case where the content of the release agent in the resin composition is more than 30 mass%. However, it is only sufficient that the content of the release agent in the resin composition is more than 0 mass%, and the content is preferably 1 mass% or more, and more preferably 2 mass% or more. In a case where the content of the release agent in the resin composition is 1 mass% or more, the shape of the groove pattern 7 is less likely to collapse and a better appearance is obtained as compared to a case where the content of the release agent in the resin composition is less than 1 mass%.

The ratio R may be 25% or less, and is preferably 22% or less or 21% or less. In this case, the conductive film 20 exhibits more excellent adhesion and chemical resistance of the first resin layer 30 as compared to a case where the above-described ratio R is more than 25%.

The above-described ratio R is preferably 20% or less, more preferably 18% or less, still more preferably 15% or less, and particularly preferably 10% or less. In this case, the conductive film 20 exhibits more excellent adhesion and chemical resistance of the first resin layer 30 as compared to a case where the ratio R is more than 20%.

The above-described ratio R may be 5% or less or 2% or less.

The above-described ratio R may be 5% or more, 10% or more, 13% or more, or 15% or more.

In Formula (1), A1 and A2 each represent the intensity of silicon-containing secondary ions derived from the release agent on the first surface 31a and the intensity of silicon-containing secondary ions derived from the release agent on the second surface 32a of the main body portion 32. Here, examples of the silicon-containing secondary ions include $SiC_3H_9^+$ and $SiO^+$.

The thickness of the first resin layer 30 may be 5100 nm or less. In this case, as compared to a case where the thickness of the first resin layer 30 is more than 5100 nm, the adhesion of the first resin layer 30 to the substrate 15 can be further improved. The thickness of the first resin layer 30 may be 5000 nm or less, 4500 nm or less, 4000 nm or less, 3500 nm or less, 3000 nm or less, 2500 nm or less, 2000 nm or less, 1500 nm or less, or 1000 nm or less from the viewpoint of further improving adhesion of the first resin layer 30 to the substrate 15.

The thickness of the first resin layer 30 is preferably 1000 nm or more. In this case, the depth of the trench 7a is increased as compared to a case where the thickness of the first resin layer 30 is less than 1000 nm, and the volume resistivity of the conductive part 5 is further decreased, resulting in further improvement in the conductivity of the conductive film 20. The thickness of the first resin layer 30 may be 2000 nm or more, 2500 nm or more, 3000 nm or more, 3500 nm or more, or 4000 nm or more from the viewpoint of further improving the conductivity of the conductive film 20.

The thickness of the surface-segregated release agent layer 31 is not particularly limited as long as it is smaller than the thickness of the first resin layer 30, and is preferably 30% or less of the thickness of the first resin layer 30. In this case, the conductive film 20 exhibits more excellent adhesion and chemical resistance of the first resin layer 30 as compared to a case where the thickness of the surface-segregated release agent layer 31 is more than 30% of the thickness of the first resin layer 30. The thickness of the surface-segregated release agent layer 31 may be 20% or less, or 10% or less.

However, the thickness of the surface-segregated release agent layer 31 may simply be more than 0 nm, and is preferably 5 nm or more, and more preferably 10 nm or more. In this case, the release component can be uniformly segregated on the surface of the first resin layer 30 as compared to a case where the thickness of the first resin layer 30 is less than 5 nm, and the releasability when a trench mold is pulled out is more excellent, so that damage to the first resin layer 30 when the mold is pulled out can be reduced. The thickness of the surface-segregated release agent layer 31 may be 50 nm or more, or 100 nm or more.

(Second Resin Layer)

The second resin layer 12 is provided between the base material 1 and the base layer 13. Therefore, adhesion between the base material 1 and the base layer 13 can be improved.

The second resin layer 12 may be a layer containing a resin and an inorganic filler. Examples of the resin constituting the second resin layer 12 include an acrylic resin. Examples of the inorganic filler include silica.

The thickness of the second resin layer 12 may be, for example, 5 nm or more, 100 nm or more, 200 nm or more, 500 nm or more, or 1 $\mu$m or more, and may be 10 $\mu$m or less, 5 $\mu$m or less, or 2 $\mu$m or less.

(Base layer)

The base layer 13 is a layer provided in order to form the conductive part 5 by electroless plating or the like. The base layer 13 may be a layer containing a catalyst and a resin. The base layer 13 may be a single layer or a laminate of a plurality of layers. The resin may be a cured product of a curable resin composition. Examples of a curable resin contained in the curable resin composition include an amino resin, a cyanate resin, an isocyanate resin, a polyimide resin, an epoxy resin, an oxetane resin, a polyester resin, an allyl resin, a phenolic resin, a benzoxazine resin, a xylene resin, a ketone resin, a furan resin, a COPNA resin, a silicon resin, a dicyclopentadiene resin, a benzocyclobutene resin, an episulfide resin, an ene-thiol resin, a polyazomethine resin, a polyvinyl benzyl ether compound, acenaphthylene, and an ultraviolet curable resin containing a functional group that causes a polymerization reaction with ultraviolet rays such as an unsaturated double bond, a cyclic ether, and a vinyl ether.

The catalyst contained in the base layer 13 may be an electroless plating catalyst. The electroless plating catalyst may be at least one metal selected from the group consisting of Pd, Cu, Ni, Al, Co, Au, Ag, Pd, Rh, Pt, In, and Sn, at least one metal selected from the group consisting of Pd, Cu, Ni, and Al, at least one metal selected from the group consisting of Pd, Cu, and Ni, or Pd. The catalyst may be used alone or in combination of two or more kinds thereof. Usually, the catalyst is dispersed in the resin as catalyst particles.

The content of the catalyst in the base layer 13 may be 3 mass% or more, 4 mass% or more, or 5 mass% or more, and may be 100 mass% or less, 50 mass% or less, or 25 mass% or less with respect to the total amount of the base layer 13.

The thickness of the base layer 13 may be 5 nm or more, 10 nm or more, or 30 nm or more, and may be 500 nm or less, 300 nm or less, or 150 nm or less.

(Groove Pattern)

The angle between two linear trenches 7a intersecting each other in the groove pattern 7 does not need to be 90 degrees, and can be, for example, in a range of 40 degrees or more and 140 degrees or less.

(Conductive Part)

The conductive part 5 is provided over a partial region of the first resin layer 30 together with the groove pattern 7.

The conductive part 5 may contain metal as a conductive material. The conductive part 5 may contain at least one metal selected from copper, nickel, cobalt, palladium, silver, gold, platinum, and tin, or may contain copper. The conductive part 5 may be metal plating formed by a plating method. The conductive part 5 may further contain a nonmetallic element such as phosphorus as long as appropriate conductivity is maintained.

The aspect ratio of the conductive part 5 may be 0.1 or more, 0.5 or more, or 1.0 or more. By setting the aspect ratio of the conductive part 5 within the above-described range, the conductivity of the conductive part 5 can be further enhanced. The aspect ratio of the conductive part 5 may be 10.0 or less, 7.0 or less, or 4.0 or less. By setting the aspect ratio of the conductive part 5 within the above-described range, the difference in transmittance due to the incident angle of light with respect to the surface 31a of the first resin layer 30 opposite to the base material 1 can be reduced. The aspect ratio of the conductive part 5 refers to a ratio of the thickness of the conductive part 5 to the width of the conductive part 5 (thickness/width).

The conductive part 5 may be a stacked body including a plurality of layers. For example, the conductive part 5 may include a first metal layer and a second metal layer sequentially formed on the base material 1. The first metal layer may contain nickel. The second metal layer may contain copper. The thickness of the first metal layer may be, for example, 5 nm or more, 10 nm or more, or 50 nm or more, and may be 500 nm or less, 200 nm or less, or 100 nm or less.

The conductive film 20 may further include a blackened layer. The blackened layer may be provided between the eyes of a viewer viewing the conductive film 20 and the conductive part 5. For example, in a case where the eyes of the viewer are positioned on the base material 1 side closer to the first resin layer 30, the blackened layer may be provided on the opposite side of the conductive part 5 farther from the base material 1. In a case where the eyes of the viewer are positioned on the main surface 1a side of the base material 1 opposite to the first resin layer 30, the blackened layer may be provided on the conductive part 5 closer to the base material 1 side. In this case, for example, the entire intermediate layer 11 may be a blackened layer, and a part of the intermediate layer 11 (the second resin layer 12 or the base layer 13) may be a blackened layer. The blackened layer can contribute to improvement in visibility of a display device in which the conductive film 20 is incorporated. The blackened layer may be a layer similar to the first metal layer, and may be, for example, a layer containing copper and nickel. In this case, the content of nickel in the blackened layer may be 15 mass% or more and 60 mass% or less with respect to the total amount of copper and nickel. The thickness of the blackened layer may be, for example, 300 nm or more and 400 nm or less. The blackened layer may be a layer formed by treating the conductive part 5 with a treatment liquid containing Pd.

(Protective Layer)

The substrate 15 or the conductive film 20 may further include a protective layer. The protective layer may be provided to cover the conductive part 5, or may be provided to cover the main surface 1a of the base material 1 opposite to the first resin layer 30. By providing the protective layer to cover the conductive part 5, scratching occurring on the conductive part 5 is minimized, and by providing the protective layer to cover the main surface 1a of the base material 1 opposite to the first resin layer 30, scratching occurring on the base material 1 is minimized. The protective layer can be a layer similar to the second resin layer 12. The thickness of the protective layer may be, for example, 5 nm or more, 50 nm or more, or 500 nm or more, and may be 10 $\mu$m or less, 5 $\mu$m or less, or 2 $\mu$m or less.

<Method for Producing Conductive Film>

The conductive film 20 can be produced, for example, by a method including pattern formation by an imprinting method. An example of a method for producing the conductive film 20 includes steps of: preparing a substrate 15 including a second resin layer 12 and a base layer 13, which are provided on one main surface of a base material 1, in this order; forming a trench-forming layer on the base layer 13 of the substrate 15; pressing a mold having linear protrusions onto the trench-forming layer, followed by pulling out the mold from a first resin layer 30 to form the first resin layer 30 having the groove pattern 7 including linear trenches 7a; and forming a conductive part 5 including linear portions 5a provided in the linear trenches 7a by a plating method including growing a metal plating from the base layer 13 exposed in the trenches 7a. In a case where the trench-forming layer is a layer containing a thermosetting resin composition as a resin composition, the first resin layer 30 may be formed by curing the trench-forming layer with heat in a state where the mold is pressed onto the trench-forming layer. Specifically, in a case where the trench-forming layer contains a photocurable resin composition, the trench-forming layer may be irradiated with ultraviolet rays while the mold is pressed onto the trench-forming layer to cure the trench-forming layer, resulting in the formation of the first resin layer 30.

The pressure applied to the trench-forming layer by the protrusions of the mold used for the imprinting method may be 2.0 MPa or less or 1.5 MPa or less.

In a case where a part of the first resin layer 30 or the second resin layer 12 remains at the bottom portion of the trenches 7a after the formation of the trenches 7a by the imprinting method, the remaining resin layer may be removed before the formation of the conductive part 5. However, in a case where the trenches 7a are formed by the imprinting method, the conductive part 5 having good conductivity can be efficiently formed by the plating method without requiring removal of the remaining resin layer.

The formation of the conductive part 5 by the plating method may include, for example, a step of forming a seed layer on the base layer 13 by an electroless plating method and a step of forming Cu plating on the seed layer by the electroless plating method. In this case, the seed layer may be the first metal layer, and the Cu plating may be the second metal layer.

<Display Device>

Next, a display device of the present disclosure will be described.

The display device of the present disclosure can include the conductive film 20 as, for example, a planar transparent antenna. The display device may be, for example, a liquid crystal display device or an organic EL display device.

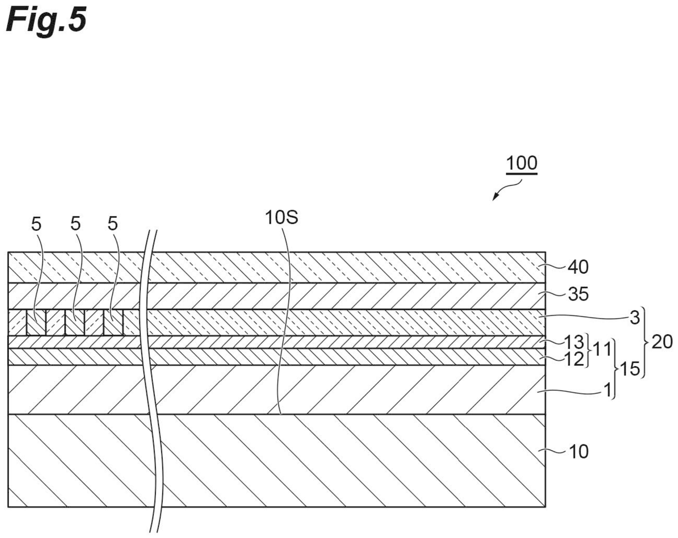

An embodiment of the display device of the present disclosure will be described with reference to FIG. 5. FIG. 5 is a cross-sectional view illustrating an example of a display device in which a conductive film is incorporated. A display device 100 illustrated in FIG. 5 includes an image display unit 10 having an image display region 10S, the conductive film 20, a polarizing plate 35, and a cover glass 40. The conductive film 20, the polarizing plate 35, and the cover glass 40 are laminated, in this order from the image display unit 10 side, on the image display region 10S side of the image display unit 10. The configuration of the display device is not limited to the form of FIG. 5, and can be appropriately changed as necessary. For example, the polarizing plate 35 may be provided between the image display unit 10 and the conductive film 20. The image display unit 10 may be, for example, a liquid crystal display unit. As the polarizing plate 35 and the cover glass 40, ones commonly used in a display device can be used. The polarizing plate 35 and the cover glass 40 may not be necessarily provided.

The present disclosure is not limited to the above-described embodiments. For example, in the above-described embodiment, the substrate 15 includes the intermediate layer 11 and the first resin layer 30 on the one main surface 1b of the base material 1, but may further include at least one of an intermediate layer 11 and a first resin layer 30 on the main surface 1a opposite to the one main surface 1b of the base material 1.

In the above-described embodiment, the groove pattern 7 and the conductive part 5 are provided over a partial region of the first resin layer 30, but may be provided over the entire region of the first resin layer 30 or the main surface of the base material 1.

Furthermore, in the above-described embodiment, the intermediate layer 11 is provided to cover the entire main surface 1b of the base material 1, but the intermediate layer 11 may be provided to cover a partial region of the main surface 1b of the base material 1. In this case, the remaining region of the main surface 1b of the base material 1 is not covered with the intermediate layer 11 but directly covered with the first resin layer 30. In this case, the thickness of the intermediate layer 11 is preferably 10% or less of the thickness of the first resin layer 30 from the viewpoint of reducing the step between a film on a partial region of the main surface 1b of the base material 1 and a film on the remaining region of the main surface 1b of the base material 1.

In the above-described embodiment, although the groove pattern 7 is formed only in the first resin layer 30, the groove pattern 7 may be formed over the first resin layer 30 and the intermediate layer 11, or may be formed over the first resin layer 30, the intermediate layer 11, and the base material 1.

The outline of the present disclosure is as follows.

[1] A conductive film including:

a substrate;
a resin layer provided on one or both of two main surfaces of the substrate; and
a groove pattern formed in at least the resin layer; and
a conductive part with which the groove pattern is filled, in which
the resin layer is obtained using a resin composition containing a release agent containing silicon and a resin,
the resin layer includes a surface-segregated release agent layer in which the release agent segregates, and a main body portion provided on a substrate side of the surface-segregated release agent layer,
the surface-segregated release agent layer has a first surface opposite to the main body portion,
the main body portion has a second surface on the substrate side,
a thickness of the resin layer is 5100 nm or less, and
in a case where the resin layer is subjected to time-of-flight secondary ion mass spectrometry in a thickness direction of the resin layer, a ratio R defined by Formula (1) using an intensity A1 of silicon-containing secondary ions derived from the release agent in the first surface of the surface-segregated release agent layer and an intensity A2 of silicon-containing secondary ions derived from the release agent in the second surface of the main body portion is 25% or less.

$$\text{Ratio R} = 100 \times A2/A1 \cdots (1)$$

[2] The conductive film according to [1], in which a thickness of the surface-segregated release agent layer is 30% or less of the thickness of the first resin layer.

[3] The conductive film according to [1] or [2], in which the ratio R is 20% or less.

[4] The conductive film according to any one of [1] to [3], in which

the substrate includes a base layer in contact with the resin layer, and
the base layer contains at least one metal selected from the group consisting of palladium, copper, nickel, and aluminum.

[5] The conductive film according to any one of [1] to [4], in which the groove pattern includes a plurality of linear trenches intersecting each other.

[6] The conductive film according to [5], in which the groove pattern is a mesh-like pattern.

[7] The conductive film according to any one of [1] to [6], in which the conductive film is used for a transparent antenna.

[8] A display device including:

an image display unit; and
a conductive film provided above the image display unit, in which
the conductive film is the conductive film according to any one of [1] to [7].

**Examples**

Although in the following, the present invention will be described more specifically with Examples, the present invention is not limited to the following Examples.

<Preparation of Base layer-Forming Composition>

A base layer-forming composition containing 0.2 mass% of Pd particles and an acrylic resin which is an ultraviolet curable resin was prepared.

<Preparation of Hard Coat Layer-Forming Composition>

A hard coat layer-forming composition containing 5 mass% of Si particles and an acrylic resin serving as an ultraviolet curable resin was prepared.

[Example 1]

First, the hard coat layer-forming composition prepared as described above was applied onto a cycloolefin polymer (COP) film (thickness: 100 $\mu$m) serving as a transparent base material by using a bar coater. The coating film was heated to 100°C and then cured by ultraviolet irradiation to form a hard coat layer (thickness: 300 nm). Thereafter, a base layer-forming layer composition prepared in the above manner was applied onto the hard coat layer using a bar coater. The coating film was heated to 100°C and then cured by ultraviolet irradiation to form a base layer (thickness: 60 nm). Thus, a substrate was obtained. Thereafter, as illustrated in Table 1, a resin layer-forming resin composition composed of a resin composition A serving as a resin composition was applied onto the base layer of the substrate to form a trench-forming layer. In this case, the resin composition A was a resin composition obtained by adding a release agent (trade name: "X-2-2445", manufactured by Shin-Etsu Chemical Co., Ltd.) to a resin composition B(trade name: "EL 1500", manufactured by Showa Denko Materials Co., Ltd., content of release agent: 2 mass%), and in the resin composition A, the amount of an additive was adjusted so that the total content of the release agent was 5 mass% as illustrated in Table 1.

On the other hand, a mold made of Ni having protrusions with a width of 1 $\mu$m for forming a mesh-like pattern was prepared. This mold was pressed onto the trench-forming layer, and the tip ends of the protrusions of the mold were made to reach the base layer. In this state, the trench-forming layer was cured by ultraviolet irradiation. As a result, the trench-forming layer was formed into a resin layer having a thickness of 2015 nm, and trenches, each having a bottom surface where the base layer was exposed, were formed in the resin layer. Each trench had a width of 1 $\mu$m and a depth of 2015 nm.

A laminate including the trench-forming layer in which the trenches were formed was immersed in an alkaline degreasing solution containing a surfactant for 5 minutes. Thereafter, the laminate taken out from the degreasing solution was washed with pure water. The washed laminate was immersed in an electroless plating solution containing nickel sulfate and sodium hypophosphite for 3 minutes to grow metal plating serving as a seed layer (thickness: 50 nm) containing Ni and P from the base layer exposed at the bottom surfaces of the trenches. The laminate taken out from the electroless plating solution was washed with pure water. Subsequently, the laminate in which the seed layer was formed was immersed in an aqueous solution containing Pd for 5 minutes and then washed with pure water to adsorb Pd particles serving as a catalyst to the seed layer. Thereafter, the laminate was immersed in an electroless plating solution containing copper sulfate and formalin for 15 minutes to grow, on the seed layer, Cu plating (upper metal plating layer) with which the trenches were filled. The laminate taken out from the electroless plating solution was washed with pure water and dried at 80°C for 3 minutes to form a mesh-like pattern, thereby obtaining a conductive film including a conductive pattern layer composed of the seed layer and the Cu plating.

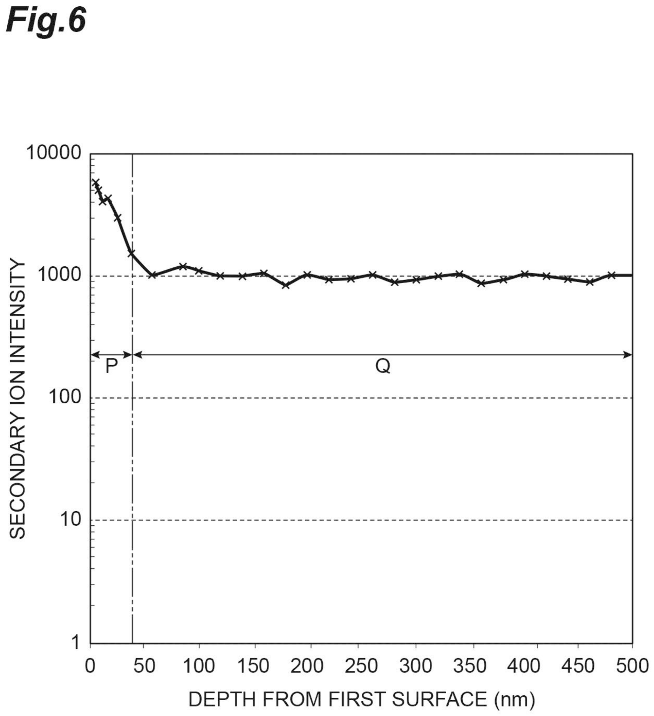

The resin layer of the conductive film thus obtained was subjected to depth direction analysis using a time-of-flight secondary ion mass spectrometry (product name "TOF.SIMS 5", manufactured by IONTOF GmbH), and the intensity (hereinafter, referred to as "secondary ion intensity") of $SiC_3H_9^+$ (silicon-containing secondary ions derived from the release agent) in the thickness direction of the resin layer was measured. In this case, sputtering was performed with a gas cluster ion beam (GCIB), and Bi (primary ion: $Bi^+$) was used as an ion for analysis. Measurement results are illustrated in FIG. 6. In FIG. 6, the vertical axis represents the secondary ion intensity, and the horizontal axis represents the depth from the first surface which is the outermost surface of the resin layer. P represents a surface-segregated release agent layer, and Q represents a main body portion. The thickness (nm) of the surface-segregated release agent layer, a secondary ion intensity A1 on the first surface that is the outermost layer, a secondary ion intensity A2 on the second surface of the main body portion, and the ratio R (= 100 × A2/A1) are illustrated in Table 1.

[Examples 2 to 5 and Comparative Examples 1 to 3]

A conductive film was obtained in the same manner as in Example 1 except that the type of the resin composition, the content of the release agent, the total thickness of the resin layer, the thickness (nm) of the surface-segregated release agent layer, the secondary ion intensity A1 on the first surface, the secondary ion intensity A2 on the second surface, and the ratio R (= 100 × A2/A1) were as illustrated in Table 1. Resin composition C is a resin composition (content of release agent: 5 mass%) having a trade name of "AM11J5" and manufactured by Changsung Sheet.

<Evaluation of Adhesion>

The conductive films obtained in Examples 1 to 5 and Comparative Examples 1 to 3 were subjected to a cross-cut test to evaluate the adhesion of the resin layer to the substrate. The cross-cut test was performed based on JISK5400. First, 11 notches were made in each of the resin layers of the conductive films obtained in Examples 1 to 5 and Comparative Examples 1 to 3 along the longitudinal direction and the lateral direction at intervals of 1 mm to form 100 squares in a lattice pattern like a Go board. Thereafter, a cellophane tape was attached to the notched region. The attached cellophane tape was peeled off, and the peeling state at 100 squares was visually observed, and the results were evaluated in 6 levels of 0, 1, 2, 3, 4, and 5. 0 indicates higher adhesion, and the adhesion gradually decreases from 0 to 5. The evaluation results of adhesion are illustrated in Table 1.

<Evaluation of Chemical Resistance>

The conductive films obtained in Examples 1 to 5 and Comparative Examples 1 to 3 were immersed in a 1% aqueous sodium hydroxide solution at 25°C as an alkaline solution for 3 minutes, and then the surface of the resin layer was observed at a magnification of 10 times using an optical microscope to evaluate chemical resistance. Evaluation criteria of chemical resistance were as follows. The results of chemical resistance are illustrated in Table 1.

(Evaluation Criteria)

◎ ··· The number of circular defects in the field of view of the microscope is 0
○··· The number of circular defects in the visual field of the microscope is more than 0 and less than 5
×··· The number of circular defects in the field of view of the microscope is 5 or more

[Table 1]

| | Resin composition | Total content of release agent (mass%) | Thickness of resin layer (nm) | Thickness of surface-segregated release agent layer (nm) | Secondary ion intensity A1 on first surface | Secondary ion intensity A2 on second surface | Ratio R (%) | Evaluation result | |
|---|---|---|---|---|---|---|---|---|---|
| | | | | | | | | Chemical resistance | Adhesion (cross-cut) |
| Example 1 | A | 5 | 2015 | 43 | 5821 | 942 | 16.2 | ◎ | 0 |
| Example 2 | B | 2 | 1991 | 13 | 5793 | 823 | 14.2 | ◎ | 0 |
| Example 3 | A | 10 | 2041 | 112 | 5864 | 1176 | 20.1 | ◎ | 0 |
| Example 4 | A | 20 | 2024 | 291 | 5913 | 1319 | 22.3 | ○ | 1 |
| Example 5 | B | 2 | 5006 | 33 | 5801 | 801 | 13.8 | ◎ | 0 |
| Comparative Example 1 | C | 5 | 2031 | 0 | 3834 | 3752 | 97.9 | ◎ | 5 |
| Comparative Example 2 | A | 30 | 2008 | 472 | 6042 | 1532 | 25.4 | × | 3 |
| Comparative Example 3 | B | 2 | 10015 | 68 | 5789 | 785 | 13.6 | ◎ | 3 |

**Reference Signs List**

| | |
|---|---|
| 5 | Conductive part |
| 7 | Groove pattern |
| 7a | Trench |
| 10 | Image display unit |
| 13 | Base layer |
| 15 | Substrate |
| 15S | Main surface |
| 20 | Conductive film |
| 30 | First resin layer (resin layer) |
| 31 | Surface-segregated release agent layer |
| 31a | First surface |
| 32 | Main body portion |
| 32a | Second surface |
| 100 | Display device |
| X | Intersecting portion |
| Y | Thickness direction of first resin layer |

**Claims**

1. A conductive film comprising:

   a substrate;
   a resin layer provided on one or both of two main surfaces of the substrate;
   a groove pattern formed in at least the resin layer; and
   a conductive part with which the groove pattern is filled, wherein
   the resin layer is obtained using a resin composition containing a release agent containing silicon, and a resin,
   the resin layer includes a surface-segregated release agent layer in which the release agent segregates, and a main body portion provided on a substrate side of the surface-segregated release agent layer,
   the surface-segregated release agent layer has a first surface opposite to the main body portion,
   the main body portion has a second surface on the substrate side,
   a thickness of the resin layer is 5100 nm or less, and
   in a case where the resin layer is subjected to time-of-flight secondary ion mass spectrometry in a thickness direction of the resin layer, a ratio R defined by Formula (1) using an intensity A1 of silicon-containing secondary ions derived from the release agent in the first surface of the surface-segregated release agent layer and an intensity A2 of silicon-containing secondary ions derived from the release agent in the second surface of the main body portion is 25% or less,

$$\text{Ratio R} = 100 \times A2/A1 \cdots (1).$$

2. The conductive film according to claim 1, wherein a thickness of the surface-segregated release agent layer is 30% or less of the thickness of the resin layer.

3. The conductive film according to claim 1, wherein the ratio R is 20% or less.

4. The conductive film according to claim 1, wherein

   the substrate includes a base layer in contact with the resin layer, and
   the base layer contains at least one metal selected from the group consisting of palladium, copper, nickel, and aluminum.

5. The conductive film according to claim 1, wherein the groove pattern includes a plurality of linear trenches intersecting each other.

6. The conductive film according to claim 5, wherein the groove pattern is a mesh-like pattern.

7. The conductive film according to claim 1, wherein the conductive film is used for a transparent antenna.

8. A display device comprising:

an image display unit; and
a conductive film provided above the image display unit, wherein
the conductive film is the conductive film according to any one of claims 1 to 7.

**Fig.1**

*Fig.2*

# Fig.3

# Fig.4

# Fig.5

# Fig.6

**EP 4 685 846 A1**

# INTERNATIONAL SEARCH REPORT

| International application No. |
|---|
| **PCT/JP2024/011127** |

| A. | CLASSIFICATION OF SUBJECT MATTER |
|---|---|

*H01L 23/12*(2006.01)i; *G09F 9/00*(2006.01)i; *H01L 23/14*(2006.01)i; *H05K 1/02*(2006.01)i
FI: H01L23/12 Z; H05K1/02 J; G09F9/00 313; H01L23/14 R; H01L23/14 M

According to International Patent Classification (IPC) or to both national classification and IPC

| B. | FIELDS SEARCHED |
|---|---|

Minimum documentation searched (classification system followed by classification symbols)

H01L23/12; G09F9/00; H01L23/14; H05K1/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | WO 2022/138000 A1 (TDK CORPORATION) 30 June 2022 (2022-06-30)<br>paragraphs [0026], [0035], [0036], [0042] | 1-8 |
| Y | JP 2011-159924 A (FUJIFILM CORPORATION) 18 August 2011 (2011-08-18)<br>paragraphs [0015], [0046] | 1-8 |

☐ Further documents are listed in the continuation of Box C.    ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **17 May 2024** | **28 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/011127**

| Patent document cited in search report | Publication date (day/month/year) | Patent family member(s) | Publication date (day/month/year) |
|---|---|---|---|
| WO 2022/138000 A1 | 30 June 2022 | (Family: none) | |
| JP 2011-159924 A | 18 August 2011 | (Family: none) | |

Form PCT/ISA/210 (patent family annex) (July 2022)

**EP 4 685 846 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019029658 A